Europäisches Patentamt

(19) European Patent Office

Office européen des brevets

(11) Publication number : **0 447 057 A2**

## (12) EUROPEAN PATENT APPLICATION

(21) Application number : 91301523.6

(22) Date of filing : 26.02.91

(51) Int. Cl.⁵ : **G06F 12/02, G11C 5/00**

(30) Priority : 06.03.90 JP 54165/90

(43) Date of publication of application :
**18.09.91 Bulletin 91/38**

(84) Designated Contracting States :
**DE FR GB IT**

(71) Applicant : **HITACHI, LTD.**
**6, Kanda Surugadai 4-chome**
**Chiyoda-ku, Tokyo 101 (JP)**

(72) Inventor : **Ishihara, Masamichi**
**2-10-21, Midorigaoka, Hamura-machi**
**Nishitama-gun, Tokyo (JP)**
Inventor : **Sakuta, Toshiyuki**
**B-106, Hitachi-fujimiso 2-1-16, Midorigaoka**
**Hamura-machi, Nishitama-gun, Tokyo (JP)**

Inventor : **Tazunoki, Masanori**
**2-18-16 Sakaecho**
**Hamura-machi, Nishitama-gun, Tokyo (JP)**
Inventor : **Nakamura, Hisashi**
**769 Shin-machi**
**Ohme-shi, Tokyo (JP)**
Inventor : **Uchiyama, Hiroyuki**
**5-19-1, Josuihon-cho**
**Kodaira-shi, Tokyo (JP)**
Inventor : **Murata, Jun**
**4-6-12, Higashi, Kunitachi-shi**
**Tokyo (JP)**
Inventor : **Sakomura, Shigetoshi**
**657-5, Nogami**
**Ohme-shi, Tokyo (JP)**

(74) Representative : **Calderbank, Thomas Roger et**
**al**
**MEWBURN ELLIS 2 Cursitor Street**
**London EC4A 1BQ (GB)**

(54) Digital computer with non-hierarchical memory.

(57)   A single storage device which is basically configured of semiconductor memories of large capacity, is employed as a main storage and an auxiliary storage for a digital processor such as personal computer. The storage device is brought into the shape of a card so as to be detachably connected to the personal computer or the like with ease.

EP 0 447 057 A2

FIG. 1

# DIGITAL PROCESSOR

This invention relates to a digital processor, and a memory card as well as a card holder. For example it relates to techniques which are especially effective when utilized for, e. g., a personal computer, and memory cards and card custody means which are used for the personal computer.

A digital processor, such as personal computer, has a main storage and an auxiliary storage. In addition, a memory card is so constructed that a plurality of semiconductor memories, such as dynamic RAMs (random access memories) or read-only memories, are mounted on a card-like base plate.

The personal computer having the main storage and the auxiliary storage is stated in, for example, "NIKKEI PERSONAL COMPUTER" issued on September 25, 1989, pp. 194-220. Besides, the memory card is stated in, for example, "LSI MEMORY CARDS AND APPLICATION TECHNIQUES" issued on February 6, 1989, pp. 25-48.

In a personal computer or the like, the system program of an operating system or the like is loaded from an auxiliary storage into a main storage in accordance with the user or use of the computer, in other words, the processing content thereof. On the other hand, data etc. stored in the main storage as the processed result of the personal computer or the like are transferred into and kept in the auxiliary storage or the like corresponding to the user or the processing content. In this regard, the inventors' study has revealed the following: The user must carry out on each occasion the operations of loading the system program held in the auxiliary storage, into the main storage and fetching the data etc. written in the main storage, into the auxiliary storage or the like. This increases the user's burden of the processing, and results in lowering the throughput of the personal computer or the like.

Meanwhile, in the memory card as referred to above, the supply voltage of the semiconductor memories is set at, for example, +5 V even in the memory array portions thereof. In this regard, the following has been revealed by the inventors's study: When each of the semiconductor memories has its density of integration heightened and its capacity enlarged under the above condition, the memory card becomes disadvantageous in the power consumption thereof, the withstand voltages of circuit elements, etc. Moreover, it is difficult to hold the stored contents of the memory card for a long term with only the built-in batteries thereof.

One preferable aim of this invention is to simplify the storage system of a personal computer or the like digital processor so as to be exclusively used, thereby to heighten the throughput of the digital processor. Another preferable aim of this invention is to lower the power consumption of a memory card in conformity with the heighened integration density and enlarged capacity thereof, and to provide effective custody means for such memory cards.

The above and other preferable aims and novel features of this invention will become apparent from the description of the specification when read in conjunction with the accompanying drawings.

Typical aspects of performance of this invention are briefly summarized as follows: The main storage and auxiliary storage of a digital processor such as personal computer are constructed in the shape of a memory card of large capacity basically configured of semiconductor memories in each of which a memory array portion is fed with an internal supply voltage having an absolute value equal or approximate to 2.5 V. In addition, an insulator film which corresponds to the information storing node of each memory cell is formed of tantalum oxide having a comparatively good withstand voltage property, and a rechargeable secondary battery is disposed within the memory card. Besides, a card holder is prepared which has the function of refreshing the stored content of the memory card or transferring it into the built-in auxiliary storage so as to conserve it for a long term, and the function of copying the system program of an operating system or the like from the auxiliary storage into the memory card and charging the secondary battery.

According to the expedient described above, the storage system of the personal computer or the like is unified and is dedicated to exclusive use every user or processing content, whereby the throughput of the personal computer or the like can be heightened. In other words, the main storage and the auxiliary storage which have heretofore been in a hierarchic architecture are brought into a non-hierarchic architecture by employing the semiconductor memories of large capacity, whereby the efficiency of use of the storage device can be heightened. Moreover, reduction in the power consumption of the memory card can be promoted in conformity with the heightened integration density and enlarged capacity of the memory card, and the stored content of the memory card can be held efficiently and for long.

In the drawings:

Fig. 1 is a block diagram showing an embodiment of a personal computer to which this invention is applied;

Fig. 2 is an exterior structural view showing an embodiment of the personal computer in Fig. 1;

Fig. 3 is a block diagram showing an embodiment of a memory card to which this invention is applied;

Fig. 4 is an exterior structural view showing an embodiment of the memory card in Fig. 3;

Fig. 5 is a block diagram showing an embodiment of a dynamic RAM in the memory card in Fig. 3;

Fig. 6 is a circuit block diagram showing an embodiment of a power source portion in the memory card in Fig. 3;

Fig. 7 is a partial circuit diagram showing an embodiment of a memory array in the dynamic RAM in Fig. 5;

Fig. 8 is a sectional structural view showing the first embodiment of a memory cell which is included in the memory array in Fig. 7;

Fig. 9 is a sectional structural view showing the second embodiment of the memory cell which is included in the memory array in Fig. 7;

Fig. 10 is a block diagram showing an embodiment of a card holder to which this invention is applied; and

Fig. 11 is an exterior structural view showing an embodiment of the card holder in Fig. 10.

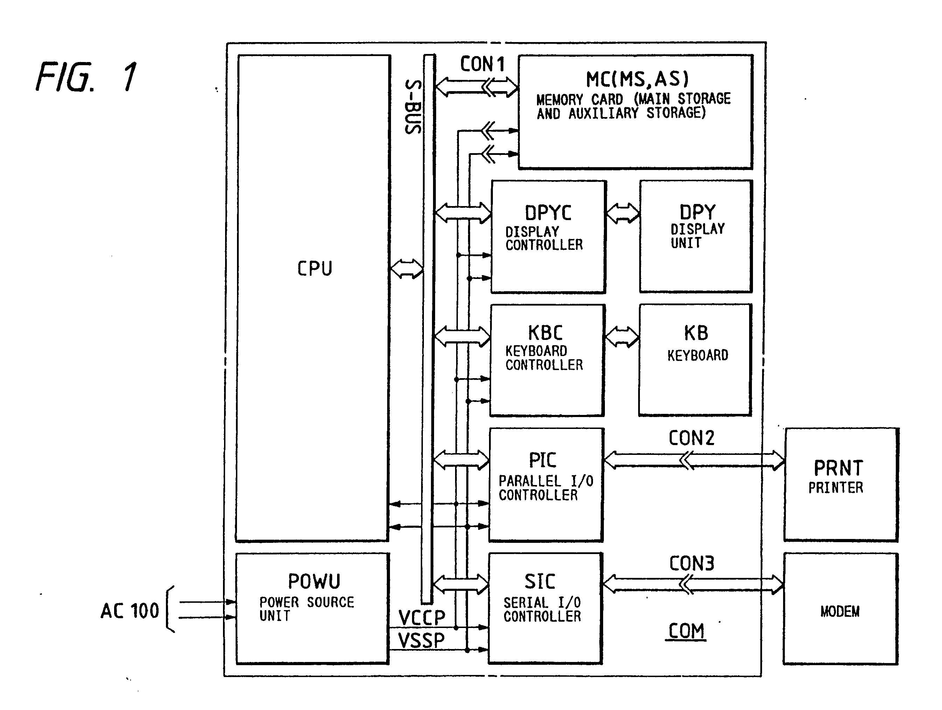

Shown in Fig. 1 is a block diagram of an embodiment of a personal computer (COM: electronic computer) to which this invention is applied.

Referring to Fig. 1, the personal computer is constructed centering round a central processing unit CPU. The central processing unit CPU is a processor of stored program type, which has an arithmetic/logic unit for executing various operational processes, a control unit for controlling the whole computer, and so forth. In addition, it has a so-called work storage such as cache memory. The central processing unit CPU is coupled to a system bus S-BUS. As will be described later, the system bus S-BUS includes an address bus, a data bus and a control bus. The central processing unit CPU is fed with a supply voltage VCCP and a ground potential VSSP as operating supply voltages from a power source unit POWU. In this embodiment, the supply voltage VCCP of circuitry is set at a plus supply voltage of, e. g., 3.3 V.

A display controller DPYC, a keyboard controller KBC, a parallel I/O controller PIC and a serial I/O controller SIC are coupled to the system bus S-BUS. Among them, the display controller DPYC has a liquid-crystal type display unit DPY coupled thereto, and the keyboard controller KBC has a keyboard KB coupled thereto. The display unit DPY and the keyboard KB are included as so-called standard equipments, and are made unitary as the personal computer proper. On the other hand, the parallel I/O controller PIC has a parallel input/output unit, for example, printer PRNT coupled thereto through a connector CON2, and the serial I/O controller SIC has a serial input/output unit, for example, modem unit MODEM coupled thereto through a connector CON3. The display controller DPYC, keyboard controller KBC, parallel I/O controller PIC and serial I/O controller SIC are fed with the supply voltage VCCP of the circuitry and the ground potential VSSP as the operating supply voltages from the power source unit POWU.

In this embodiment, a memory card MC is further coupled to the system bus S-BUS through a connector CON1. As will be described later, the memory card MC has a storage capacity of 128 megabytes (one megabyte being $10^6$ bytes) and functions as what are called the main storage MS and auxiliary storage AS of the personal computer. That is, in the personal computer of this embodiment, the main storage MS and auxiliary storage AS are realized by the single memory card MC which can be easily connected and detached. Thus, the users of the personal computers are permitted to use the system programs of operating systems or the likes, data items, etc. individually and exclusively by preparing the dedicated memory cards MC which correspond to the respective individual persons or processing contents. As a result, the user's burden of the processing is relieved, while the personal computer has its storage system simplified and has its throughput enhanced.

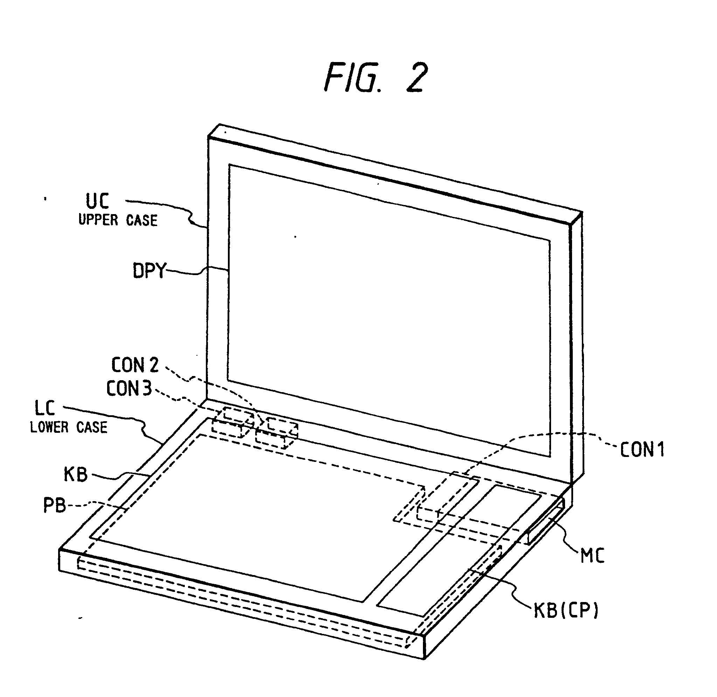

Fig. 2 shows an exterior structural view of an embodiment of the personal computer in Fig. 1.

Referring to Fig. 2, the personal computer is constructed as a so-called note type lap-top computer, which has an upper case UC and a lower case LC in a pair coupled by hinges. Of the cases, the upper one UC has the display unit DPY mounted thereon. In addition, the keyboard KB which includes a control panel CP is mounted on the front surface of the lower case LC, and a printed circuit board PB on which the central processing unit CPU and the several controllers are installed is mounted in the lower case LC. An insertion port for setting the memory card MC is provided in the right side surface of the lower case LC, and the connector CON1 for connecting the memory card MC is mounted at the deep part of the port. Further, the respective connectors CON2 and CON3 for connecting the printer PRNT and the modem MODEM are interiorly mounted on the rear surface of the lower case LC.

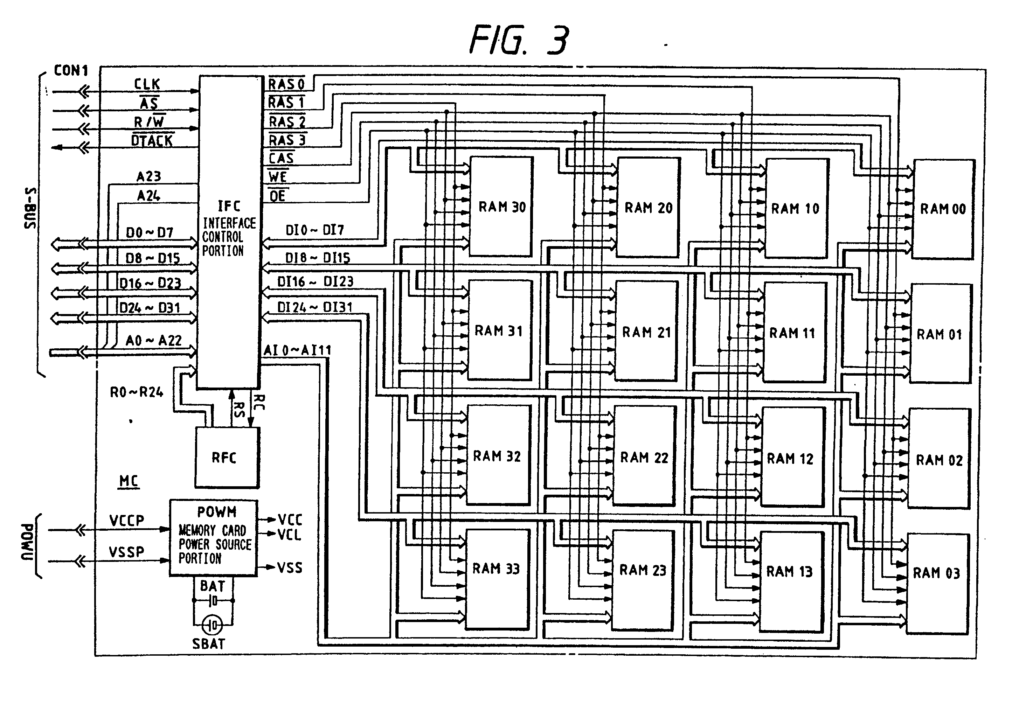

Fig. 3 shows a block diagram of an embodiment of the memory card MC which is applied to the personal computer in Fig. 1.

Referring to Fig. 3, the memory card MC is basically configured of 16 dynamic random access memories RAM00 - RAM03 thru RAM30 - RAM33. Each of these dynamic RAMs has a storage capacity of 64 megabits, namely, 8 megabytes, so that the memory card MC has a storage capacity of 1024 megabits, namely, 128 megabytes, in other words, 32 bits x 32 megawords.

As illustrated in Fig. 3, the random access memories RAM00 - RAM03 thru RAM30 - RAM33 are coupled to and controlled by an interface control portion IFC. The interface control portion IFC is further coupled to the system bus S-BUS through the connector CON1.

As exemplified in Fig. 3, the system bus S-BUS comprises address buses A0 - A24 of 25 bits and data buses D0 - D31 of 32 bits. Further, it comprises control buses for signals which include a clock signal CLK, an address strobe signal $\overline{AS}$, a read/write signal $R/\overline{W}$ and a data transfer acknowledgement signal $\overline{DTACK}$. In this embodiment, address signals, data and the several control signals which are transmitted through the corresponding buses have the supply voltage VCCP set as their high level and the ground potential VSSP set as their low level.

Among the 25-bit address signals which are supplied through the address buses of the system bus S-BUS, the address signals A23 and A24 of the two uppermost bits are separated by the interface control portion IFC as block select signals, on the basis of which row address strobe signals $\overline{RAS0}$ - $\overline{RAS3}$ are selectively formed. One $\overline{RAS0}$ of these address strobe signals is supplied in common to the four random access memories RAM00 - RAM03 which are arranged in the vertical direction of Fig. 3, namely, in an identical column, and the others $\overline{RAS1}$ thru $\overline{RAS3}$ are respectively supplied in common to the four random access memories RAM10 - RAM13 thru RAM30 - RAM33 which are arranged in the same columns. Thus, the 16 dynamic RAMs are vertically divided into blocks each consisting of four RAMs.

On the other hand, the remaining 23-bit address signals A0 - A22 are multiplexed in time-division fashion in the form in which the 12 upper bits or the address signals A11 - A22 are set as X address signals AX0 - AX11, while the 11 lower bits or the the address signals A0 - A10 are set as Y address signals AY0 - AY10, and they are supplied in common to all the dynamic RAMs as internal address signals AI0 - AI11. As is well known, internal address signal lines AI0 - AI11 are fed with the X address signals AX0 - AX11 in synchronism with the trailing edges of the row address strobe signals $\overline{RAS0}$ - $\overline{RAS3}$ and are also fed with the Y address signals AY0 - AY10 in synchronism with the trailing edge of a column address strobe signal $\overline{CAS}$.

Next, the 32-bit data items D0 - D31 which are transmitted through the data buses of the system bus S-BUS are separated every 8 bits, namely, every byte by the interface control portion IFC, and the separated data items are transmitted to the corresponding four dynamic RAMs. More specifically, the data items D0 - D7 of the 8 lower bits are transmitted as internal data items DI0 - DI7 to the four random access memories RAM00 - RAM30 which are arranged in the horizontal direction of Fig. 3, namely, in an identical row. Likewise, the data items D8 - D15 thru D24 - D31 are respectively transmitted as internal data items DI8 - DI15 thru DI24 - DI31 to the four random access memories RAM01 - RAM31 thru RAM03 - RAM33 which are arranged in the same rows. Thus, the 16 dynamic RAMs are horizontally divided into bytes each consisting of four RAMs.

The interface control portion IFC of the memory card MC further forms the row address strobe signals $\overline{RAS0}$ - $\overline{RAS3}$ as well as the column address strobe signal $\overline{CAS}$, a write enable signal $\overline{WE}$ and an output enable signal $\overline{OE}$ in accordance with predetermined timing conditions, on the basis of the clock signal CLK, address strobe signal $\overline{AS}$, read/write signal $R/\overline{W}$ and data transfer acknowledgement signal $\overline{DTACK}$ transmitted through the control buses of the system bus S-BUS and the address signals A23 and A24 of the 2 upper bits. Among the signals thus formed, the row address strobe signals $\overline{RAS0}$ - $\overline{RAS3}$ are respectively supplied in common to the four dynamic RAMs of the corresponding blocks as stated before, and the column address strobe signal $\overline{CAS}$, write enable signal $\overline{WE}$ and output enable signal $\overline{OE}$ are supplied in common to all the dynamic RAMs.

Meanwhile, the address signals, data items and several control signals which are transmitted through the system bus S-BUS have their high level set at the supply voltage VCCP and their low level set at the ground potential VSSP as stated before. In addition, as will be stated later, the random access memories RAM00 - RAM03 thru RAM30 - RAM33 use an internal supply voltage VCL of comparatively small absolute value as their operating supply voltage and have the high levels of their input/output signals set small correspondingly. To this end, the interface control portion IFC comprises a level conversion circuit whose operating supply voltage is the supply voltage VCCP and which compresses the amplitudes of the address signals, data items and several control signals so as to correspond to the internal supply voltage VCL.

The memory card MC further comprises a refresh control portion RFC as well as a memory-card power source portion POWM, and a secondary battery BAT as well as a solar battery SBAT. Among them, the refresh control portion RFC includes a refresh address counter of 25 bits and a timer circuit. Herein, refresh address signals R0 - R24 are formed as the output signals of the refresh address counter, while a refresh start signal RS is formed as the output signal of the timer circuit. These signals are fed to the interface control portion IFC.

The interface control portion IFC executes the operation of refreshing the dynamic RAM, in accordance with the refresh start signal RS. On this occasion, the interface control portion IFC selects any of the refresh address signals R0 - R24 as an address signal, and it forms a refresh completion signal RC and supplies this signal to the refresh control portion RFC when the refresh operation has ended. The refresh completion signal RC is used for the operation of updating the refresh address counter.

On the other hand, the memory-card power source portion POWM is fed with the supply voltage VCCP and the ground potential VSSP through the corresponding terminals of the connector CON1. The memory-card power source portion POWM forms the internal supply voltage VCL mentioned above and the supply voltage VCC of the circuitry corresponding to the supply voltage VCCP, on the basis of the supply voltage VCCP and ground potential VSSP or the output voltages of the secondary battery BAT and solar battery SBAT, and it feeds the formed voltages to the corresponding portions of the memory card MC. Of the formed voltages, the supply voltage VCC of the circuitry is fed as the operating supply voltages of the interface control portion IFC and refresh control portion RFC. Besides, the internal supply voltage VCL is endowed with the comparatively small absolute value of, e. g., 2.5 V and is fed as the operating supply voltages of the random access memories RAM00 - RAM03 thru RAM30 - RAM33.

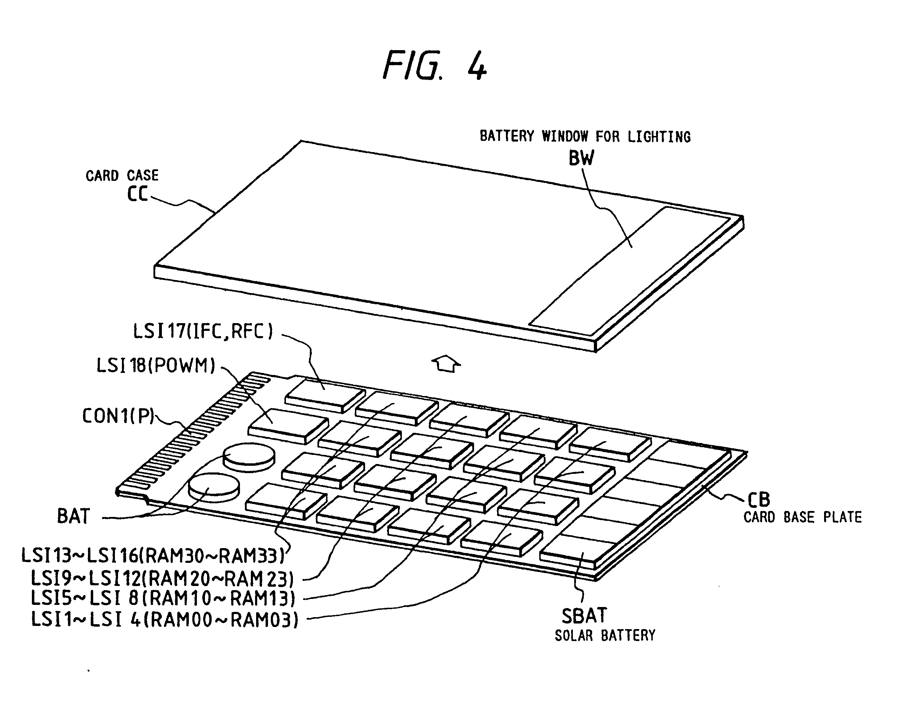

Fig. 4 shows an exterior structural view of an embodiment of the memory card MC in Fig. 3.

Referring to Fig. 4, the portions constituting the memory card MC are mounted on a card base plate CB and are protected by a card case CC. A bank of terminals corresponding to the plug parts of the connector CON1 are formed on one side of the card base plate CB, and an integrated circuit LSI17 containing the interface control portion IFC as well as the refresh control portion RFC, an integrated circuit LSI18 containing the memory-card power source portion POWM, and the secondary battery BAT consisting of two unit cells are installed near the bank of terminals. The solar battery SBAT is installed on the other side of the card base plate CB, and 16 integrated circuits LSI1 - LSI16 corresponding to the random access memories RAM00 - RAM03 thru RAM30 - RAM33 are arranged in a checkered pattern inside the solar battery. A battery window for lighting BW is provided in that part of the card case CC which corresponds to the photosensitive face of the solar battery SBAT.

In this manner, the rechargeable secondary battery is employed as the built-in battery means of the memory card, whereby the service term of the battery means can be prolonged. Moreover, the solar battery is disposed substantially in a parallel relationship with the secondary battery, whereby the burden of the secondary battery in the case where the memory card is not connected to the personal computer or the like can be relieved to prolong the service term thereof. It turns out that the burden of processing to the user of the personal computer is, in effect, relieved.

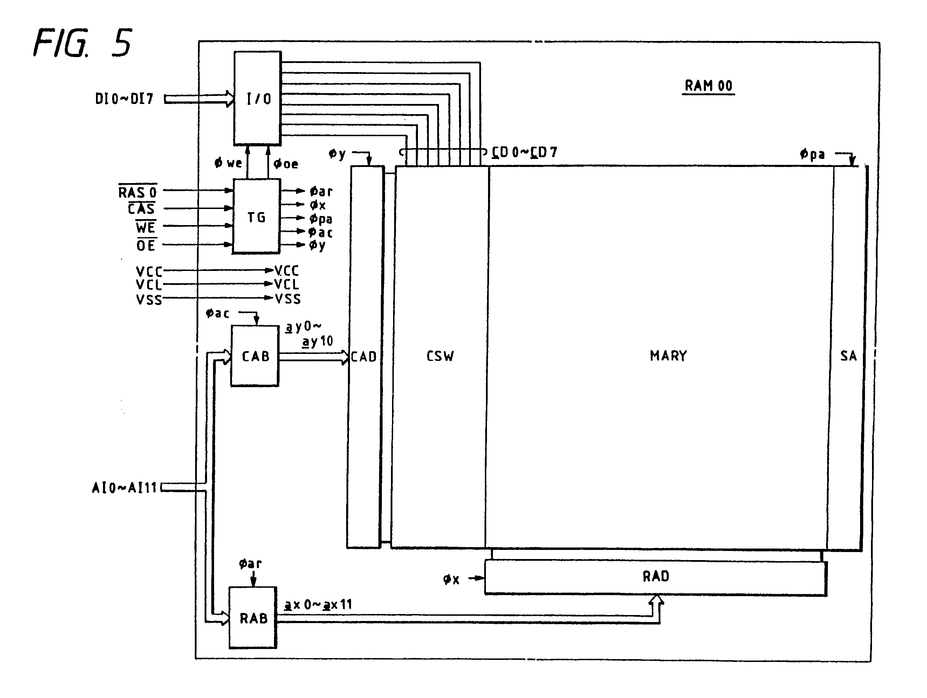

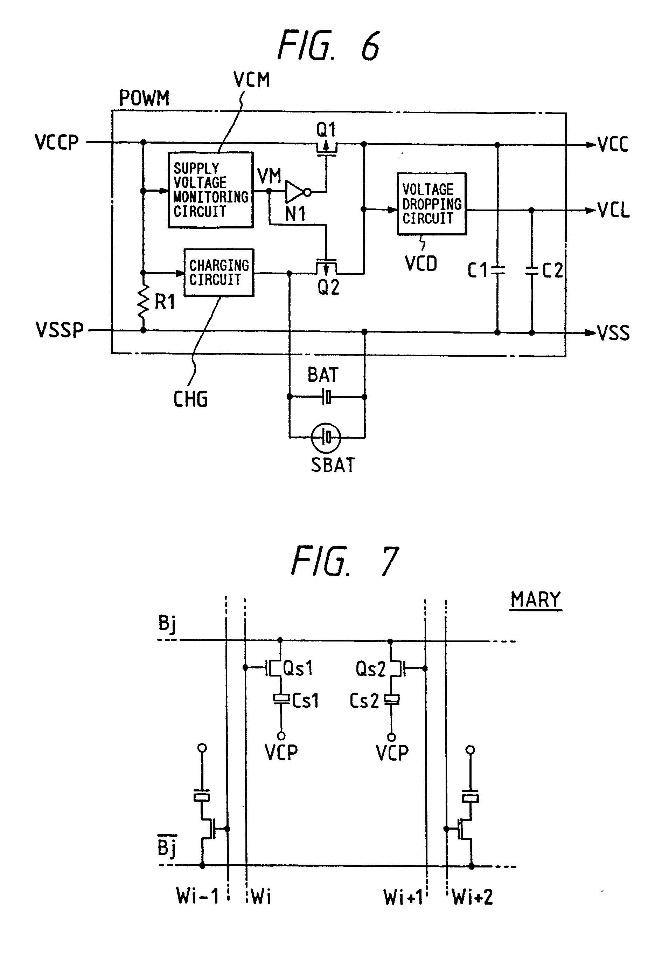

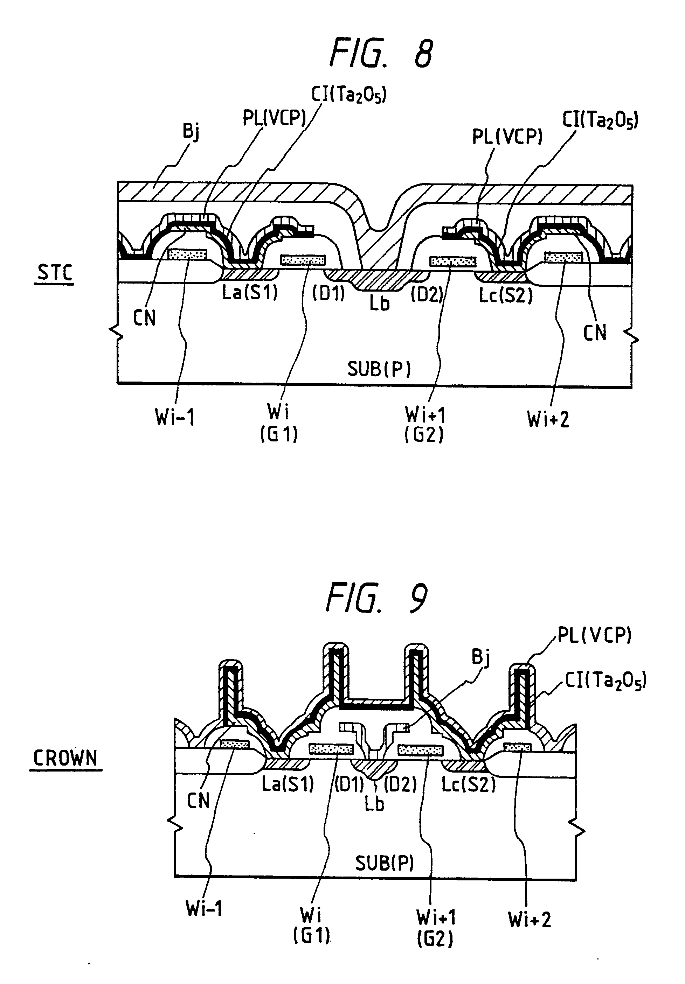

Fig. 5 shows a block diagram of an embodiment of the dynamic RAM which is installed in the memory card MC in Fig. 3. Further, Fig. 7 shows a partial circuit diagram of an embodiment of the memory array of the dynamic RAM in Fig. 5, and Figs. 8 and 9 show sectional structural views of the first and second embodiments of a memory cell which is included in the memory array in Fig. 7. Now, the outlines of the construction and operation of the dynamic RAM of this embodiment and the features of the RAM will be described by taking the random access memory RAM00 as an example. Incidentally, the dynamic RAM of this embodiment has its operating supply voltage set at the internal supply voltage VCL whose absolute value is 2.5 V, as stated before. Circuit elements which constitute blocks in Fig. 5 are formed on a single P-type semiconductor substrate. In the drawings to be referred to below, a MOSFET with an arrow affixed to its channel (back gate) portion (the expression "MOSFET" is the abbreviation of "metal-oxide-semiconductor field effect transistor", and it shall be the general name of insulated-gate field effect transistors in this specification) is of the P-channel type and is illustrated in distinction from an N-channel MOSFET to which no arrow is affixed. Besides, in each of Figs. 8 and 9, a metal wiring layer etc. formed on a plate PL are omitted from illustration.

Referring to Fig. 5, as typically shown by the random access memory RAM00, each of the random access memories RAM00 - RAM03 thru RAM30 - RAM33 is basically constructed of a memory array MARY which is formed occupying the greater part of the area of the semiconductor substrate.

The memory array MARY includes word lines in a substantial total number of 4096, which are arranged in parallel in the vertical direction of Fig. 5, complementary bit lines in a substantial total number of sets of 16384, which are arranged in parallel in the horizontal direction of the figure, and dynamic memory cells in a substantial total number of 67108864, which are arranged in a checkered pattern at the intersection points between the word lines and the complementary bit lines. Among the included elements, the sets of complementary bit lines are divided every 8 sets into bit line groups totaling 2048, and they are selectively connected to a data input/output circuit I/O with the bit line group as a unit. Thus, each of the dynamic RAMs has a storage capacity of 64 megabits and has 4096 row address spaces as well as 2048 column address spaces.

As exemplified in Fig. 7, each of the memory cells constituting the memory array MARY is the so-called dynamic memory cell, which includes an information storing capacitor $Cs1$ ($Cs2$) and an address selecting MOSFET $Qs1$ ($Qs2$) as one pair. The address selecting MOSFETs $Qs1$ ($Qs2$) of the memory cells totaling 4096, which are arranged in the identical column of the memory array MARY, have their drains coupled to the non-inverting bit lines $Bj$ and inverting bit lines $\overline{Bj}$, etc. of the corresponding sets of complementary bit lines, alternately with a predetermined regularity. Besides, the address selecting MOSFETs $Qs1$ ($Qs2$) of the memory cells totaling 16384, which are arranged in the identical row of the memory array MARY, have their gates coupled to the corresponding word lines $Wi$ and $Wi+1$, etc. in common. The address selecting MOSFET $Qs1$ ($Qs2$) of each memory cell has its source coupled to the electrode CN of the corresponding information storing capacitor $Cs1$ ($Cs2$)

on the storing node side thereof. Herein, the other electrode of the information storing capacitor Cs1 (Cs2) of each memory cell is fed with a cell plate voltage VCP whose level is 1/2 of the internal supply voltage VCL.

In this embodiment, each of the memory cells constituting the memory array MARY is constructed as a memory cell of the so-called STC (stacked capacitor) type or a memory cell of the so-called crown type as shown in Fig. 8 or Fig. 9, and the insulator film of the memory cell corresponding to the storing node is formed using tantalum oxide ($Ta_2O_5$) of comparatively good withstand voltage property as its material.

More specifically, in the case of Fig. 8, the surface of the P-type semiconductor substrate SUB is formed with, for example, a diffused layer La which constructs the source S1 of the address selecting MOSFET Qs1 in Fig. 7, a diffused layer Lc which constructs the source S2 of the address selecting MOSFET Qs2, and a diffused layer Lb which constructs the drains D1 and D2 of these MOSFETs. Among the diffused layers, one Lb is coupled to the non-inverting bit line Bj formed of a metal wiring layer of aluminum or the like, and the others La and Lc are respectively coupled to the electrodes CN of the corresponding information storing capacitors Cs1 and Cs2 on the storing node sides thereof. Each of the electrodes CN is overlaid with the insulator film CI made of tantalum oxide, which is further overlaid with the other electrode, namely, the plate PL of the information storing capacitor Cs1 or Cs2. The plate PL is fed with the cell plate voltage VCP through a contact not shown. The interspace between the source S1 and drain D1 of the address selecting MOSFET Qs1 or the interspace between the source S2 and drain D2 of the address selecting MOSFET Qs2, that is, the channel of the address selecting MOSFET is overlaid with the word line Wi or Wi+1 with a predetermined insulator film interposed therebetween. Needless to say, the word lines function as the gates G1 and G2 of the address selecting MOSFETs Qs1 and Qs2, respectively.

On the other hand, in the case of Fig. 9, the bit line Bj which is coupled to a diffused layer Lb is formed under the plate PL, and the electrodes CN of the information storing capacitors Cs1 and Cs2 on the storing node sides thereof are formed in the shape of protrusions perpendicular to the semiconductor substrate SUB. Herein, the electrodes CN are overlaid with the insulator film CI of tantalum oxide, which is further overlaid with the plate PL(VCP).

In this manner, the memory array MARY is configured of the STC type or crown type memory cells, and the insulator film of each memory cell corresponding to the storing node is formed of tantalum oxide having the comparatively good withstand voltage property, whereby the memory cells can be reduced in size for a higher density of integration while attaining a satisfactory withstand voltage property.

Referring back to Fig. 5, the word lines constituting the memory array MARY are coupled to a row address decoder RAD, and one of them is brought into a selected state.

The row address decoder RAD is fed with complementary internal address signals ax0 - ax11 of 12 bits from a row address buffer RAB (Here, a non-inverted internal address signal ax0 and an inverted internal address signal $\overline{ax0}$, for example, shall be expressed as the complementary internal address signals ax0 in combination. The same shall apply to complementary signals and complementary signal lines below.) and with a timing signal Øx from a timing generator circuit TG.

The row address decoder RAD is selectively brought into an operating state in response to the timing signal Øx set at its high level. In the operating state, the row address decoder RAD decodes the complementary internal address signals ax0 - ax11 and brings the corresponding one of the word lines of the memory array MARY into the selected state of high level.

The row address buffer RAB accepts X address signals AX0 - AX11 which are transmitted as the internal address signals AI0 - AI11 from the interface control portion IFC in time-division fashion, in accordance with a timing signal Øar fed from the timing generator circuit TG, and it holds the accepted signals. In addition, it forms the complementary internal address signals ax0 - ax11 on the basis of the held X address signals and delivers them to the row address decoder RAD.

Meanwhile, each of the sets of complementary bit lines constituting the memory array MARY is coupled to the corresponding unit amplifier circuit of a sense amplifier SA on one side thereof and to the corresponding switch MOSFETs of a column switch CSW on the other side thereof.

The sense amplifier SA includes the unit amplifier circuits in the total number of 16384, which are disposed in correspondence with the respective sets of complementary bit lines of the memory array MARY. The unit amplifier circuits are fed with a timing signal Øpa in common from the timing generator circuit TG.

All the unit amplifier circuits of the sense amplifier SA are selectively brought into operating states in response to the timing signal Øpa set at its high level. In the operating states, the respective unit amplifier circuits amplify infinitesimal readout signals which are delivered through the corresponding sets of complementary bit lines from the 16384 memory cells coupled to the selected word line of the memory array MARY, and they provide binary readout signals of high level or low level.

The column switch CSW includes the switch MOSFETs totaling 16384 pairs, which are disposed in correspondence with the respective sets of complementary bit lines of the memory array MARY. On one hand, the pairs of switch MOSFETs are respectively coupled to the corresponding sets of complementary bit lines of the memory array MARY as stated before, while on the other hand, they are successively coupled to eight sets of complementary common data lines CD0 - CD7 in such a manner that every eight pairs are coupled in common. The gates of the adjoining eight pairs of switch MOSFETs are respectively coupled in common, and are respectively fed with corresponding bit line select signals from a column address decoder CAD.

The adjoining eight pairs of switch MOSFETs of the column switch CSW are brought into "on" states selectively and simultaneously when the corresponding one of the bit line select signals is selectively set at its high level. Thus, the corresponding eight sets of complementary bit lines of the memory array MARY are selectively connected to the complementary common data lines CD0 - CD7.

The column address decoder CAD is fed with complementary internal address signals $ay0$ - $ay10$ of 11 bits from a column address buffer CAB, and with a timing signal $\emptyset y$ from the timing generator circuit TG.

The column address decoder CAD is selectively brought into an operating state in response to the timing signal $\emptyset y$ set at its high level. In the operating state, the column address decoder CAD decodes the complementary internal address signals $ay0$ - $ay10$ and brings the corresponding ones of the bit line select signals to the high level. As stated before, the bit line select signals are respectively fed to the corresponding eight pairs of switch MOSFETs of the column switch CSW.

The column address buffer CAB accepts Y address signals AY0 - AY10 which are transmitted as the internal address signals AI0 - AI11 from the interface control portion IFC in time-division fashion, in accordance with a timing signal $\emptyset ac$ fed from the timing generator circuit TG, and it holds the accepted signals. In addition, it forms the complementary internal address signals $ay0$ - $ay11$ on the basis of the held Y address signals and delivers them to the column address decoder CAD.

The sets of complementary common data lines CD0 - CD7 are coupled to the data input/output circuit I/O. This data input/output circuit I/O is fed with timing signals $\emptyset we$ and $\emptyset oe$ from the timing generator circuit TG.

The data input/output circuit I/O comprises eight data input buffers and eight data output buffers which are respectively disposed in correspondence with the sets of complementary common data lines CD0 - CD7. Among the buffers, the individual data input buffers have their input terminals respectively coupled to the corresponding internal data input/output lines DI0 - DI7 and have their output terminals respectively coupled to the corresponding complementary common data lines CD0 - CD7. The data input buffers are fed with the timing signal $\emptyset we$ in common.

When the dynamic RAM is set into its write mode and the timing signal $\emptyset we$ is set at its high level, the data input buffers are selectively brought into operating states. In the operating states, the individual data input buffers form complementary write signals conforming to write data items which are delivered through the internal data input/output lines DI0 - DI7, and they deliver the formed signals to the selected memory cells of the memory array MARY through the corresponding complementary common data lines CD0 - CD7. When the timing signal $\emptyset we$ is set at its low level, the outputs of the data input buffers are brought into high impedance states.

On the other hand, the individual data output buffers of the data input/output circuit I/O have their input terminals respectively coupled to the corresponding complementary common data lines CD0 - CD7 and have their output terminals, in effect, coupled to the internal data input/output lines DI0 - DI7 in common. The data output buffers are fed with the timing signal $\emptyset oe$ in common.

When the dynamic RAM is set into its read mode and the timing signal $\emptyset oe$ is set at its high level, the data output buffers are selectively brought into operating states. In the operating states, the individual data output buffers further amplify the binary readout signals which are delivered from the selected memory cells of the memory array MARY through the corresponding complementary common data lines CD0 - CD7, and they transmit the amplified signals to the interface control portion IFC of the memory card MC through the corresponding internal data input/output lines DI0 - DI7.

The timing generator circuit TG forms the several timing signals on the basis of the row address strobe signal $\overline{RAS0}$, column address strobe signal $\overline{CAS}$, write enable signal $\overline{WE}$ and output enable signal $\overline{OE}$ which are fed as the start control signals from the interface control portion IFC, and it delivers the formed signals to the corresponding portions of the dynamic RAM.

In this embodiment, as described before, the random access memories RAM00 - RAM03 thru RAM30 - RAM33 use the internal supply voltage of comparatively small absolute value VCL as their operating supply voltage, and the internal address signals AI0 - AI10, internal data items DI0 - DI31 and start control signals, which are transferred between the individual dynamic RAMs and the interface control portion IFC, have their signal amplitudes compressed in conformity with the internal supply voltage VCL. As also described before, the memory cells constituting the memory array MARY are implemented as the STC type or the crown type, and the insulator film of the memory cell corresponding to the storing node thereof is formed using tantalum oxide of comparatively good voltage withstand property as its material. As a result, the higher integration density and larger storage capacity of the dynamic RAM are attained, and reduction in the power consumption of the memory card MC is promoted.

Fig. 6 shows a circuit block diagram of an embodiment of the memory-card power source portion POWM of the memory card MC in Fig. 3.

Referring to Fig. 6, the memory-card power source portion POWM of the memory card MC includes a supply voltage monitoring circuit VCM and a charging circuit CHG which receive the supply voltage VCCP, and a high resistance R1 which is interposed between the input terminals of these circuits and the ground potential VSSP. In addition, it includes P-channel MOSFETs Q1 and Q2 which are respectively interposed between the feed points of the supply voltage VCCP and the supply voltage VCC and between the + electrode of the secondary battery BAT as well as the solar battery SBAT and the feed point of the supply voltage VCC, and a voltage dropping circuit VCD which receives the supply voltage VCC. Further, it includes supply voltage smoothing capacitors C1 and C2 which are respectively interposed between the feed point of the supply voltage VCC and the ground potential VSS of circuitry and between the output terminal of the voltage dropping circuit VCD, namely, the feed point of the internal supply voltage VCL and the ground potential VSS of the circuitry. In this embodiment, the absolute value of the supply voltage VCCP is set to be integral times the unit output voltage of the secondary battery BAT as well as the solar battery SBAT. Besides, the capacitance of the supply voltage smoothing capacitor C2 is set to be sufficiently large as compared with that of the other capacitor C1.

The output signal VM of the supply voltage monitoring circuit VCM is fed to the gate of the MOSFET Q2, while it is inverted by an inverter circuit N1, the inverted signal being fed to the gate of the MOSFET Q1. The output terminal of the charging circuit CHG is coupled to the + electrodes of the secondary battery SAB and solar battery SBAT in common.

When the memory card MC is connected to the personal computer or a card holder to be described later and is fed with the predetermined supply voltage VCCP through the corresponding terminal of the connector CON1, the output signal VM of the supply voltage monitoring circuit VCM is set at its high level, e.g., the supply voltage VCCP of the circuitry. Therefore, the MOSFET Q2 falls into an "off" state, and the MOSFET Q1 falls into an "on" state because the output signal of the inverter circuit N1 becomes its low level. As a result, the supply voltage VCCP is fed to the voltage dropping circuit VCD and the interface control portion IFC, etc. as the supply voltage VCC of the circuitry. On this occasion, the charging circuit CHG is brought into an operating state, and the operation of charging the secondary battery BAT is performed in parallel.

In contrast, when the memory card MC is not connected to the personal computer or the card holder and is not fed with the supply voltage VCCP, the output signal VM of the supply voltage monitoring circuit VCM is set at its low level, e. g., the ground potential of the circuitry. Therefore, the MOSFET Q1 falls into an "off" state because the output signal of the inverter circuit N1 becomes its high level, and the MOSFET Q2 falls into an "on" state instead. As a result, the output voltages of the secondary battery BAT and solar battery SBAT are fed to the voltage dropping circuit VCD and the interface control portion IFC, etc. as the supply voltage VCC of the circuitry. On this occasion, the charging operation of the secondary battery BAT by the charging circuit CHG is stopped. As stated before, the capacitance of the supply voltage smoothing capacitor C2 is set sufficiently larger than that of capacitor C1. Therefore, when the memory card MC is pulled out, the internal supply voltage VCL is prevented from lowering temporarily.

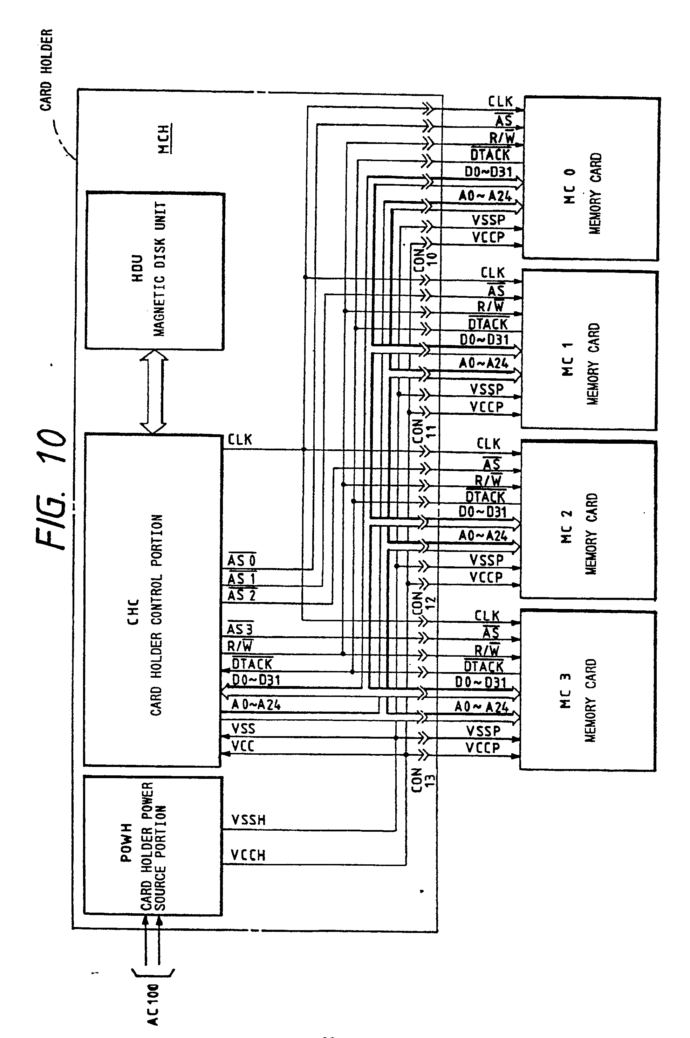

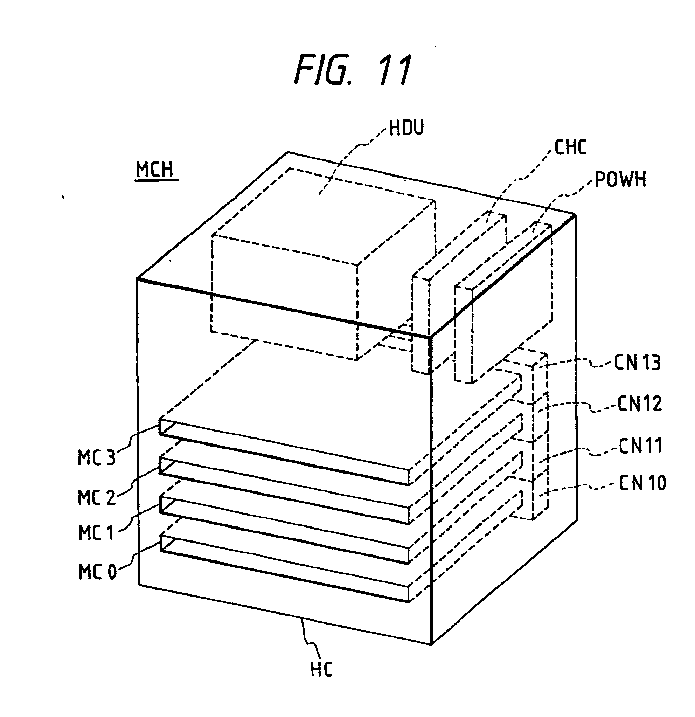

Fig. 10 shows a block diagram of an embodiment of the card holder MCH to which this invention is applied, while Fig. 11 shows an exterior structural view of an embodiment of the card holder in Fig. 10.

Referring to Fig. 10, the card holder MCH of this embodiment comprises a card-holder control portion CHC and a card-holder power source portion POWH and also comprises a magnetic disk unit HDU as an auxiliary memory. In addition, the card holder MCH of this embodiment is constructed so as to be capable of simultaneously connecting up to four memory cards MC as shown in Figs. 3 and 4, and it comprises four connectors CON10 - CON13 therefor. As shown in Fig. 11, the various portions of the card holder MCH are installed in a holder case HC. The holder case HC is provided with four insertion slots for connecting the memory cards MC0 - MC3.

The card holder MCH has the following functions for the memory cards in the number of at most four, which are simultaneously connected thereto through the connectors CON10 - CON13:

(1) The system program of an operating system or the like, data to be used for arithmetic processing, etc. which are written into the magnetic disk unit HDU beforehand are copied onto the memory cards MC0 - MC3.

(2) Data etc. which are written on the memory cards MC0 - MC3 as the processed results of the personal computer or the like are transferred into the magnetic disk unit HDU.

(3) A predetermined supply voltage is applied to the memory cards MC0 - MC3 so as to refresh the stored contents thereof.

(4) A predetermined supply voltage is applied to the memory cards MC0 - MC3 so as to charge the secondary batteries BAT thereof.

In regard of these functions, 25-bit address signal lines A0 - A24 corresponding to the address buses of the system bus S-BUS, and 32-bit data input/output lines D0 - D31 corresponding to the data buses are laid between the card-holder control portion CHC of the card holder MCH and the memory cards MC0 - MC3. Besides, a clock signal line CLK, four address strobe signal lines $\overline{AS0}$ - $\overline{AS3}$, a read/write signal line R/$\overline{W}$ and a data transfer acknowledgement signal line $\overline{DTACK}$ are laid in correspondence with the control buses of the system bus S-BUS. Among the control signals, the address strobe signals $\overline{AS0}$ - $\overline{AS3}$ are selectively formed for selectively designating the memory cards MC0 - MC3. Since the interface between the card holder MCH and each memory card is the same as in the case of the system bus S-BUS of the personal computer, it shall be omitted from description.

The card-holder power source portion POWH of the card holder MCH forms a supply voltage VCCH and a ground potential VSSH respectively corresponding to the supply voltage VCCP and the ground potential VSSP, on the basis of A.C. 100 V fed from outside, and it feeds the formed voltages to the card-holder control portion CHC, the memory cards MC0 - MC3, etc. In the memory cards MC0 - MC3, using the supply voltage VCCH and the ground potential VSSH as their operating supply voltages, the transfer or copy of the system program, data etc. or the refresh operations of the stored contents by the card-holder control portion CHC is/are executed, and the secondary batteries BAT are charged in parallel.

By preparing the card holder MCH which has the functions of writing the system program etc. into the memory cards MC, transferring or refreshing the stored contents, and charging the secondary batteries BAT in this manner, the management of the memory cards MC and the custody thereof for a long term can be realized reliably and efficiently.

As indicated by the foregoing embodiments, the following functional effects are attained when this invention is applied to a digital processor such as personal computer and to memory cards and a card holder for the digital processor:

(1) A single storage device which is basically configured of semiconductor memories of large capacity is employed as the main storage and auxiliary storage of a digital processor such as personal computer, thereby to produce the effect that the storage system of the digital processor can be simplified.

(2) In the above item (1), the storage device is brought into the shape of a card and is permitted to be easily connected to and detached from the personal computer or the like, thereby to produce the effect that the storage system including the system program etc. of the personal computer or the like can be dedicated in correspondence with a user or a processing content.

(3) Owing to the above items (1) and (2), there is produced the effect that the user's burden of processing is relieved, so the throughput of the personal computer or the like can be enhanced accordingly.

(4) In the above items (1) and (2), the memory card is basically configured of dynamic RAMs, and an internal supply voltage to be fed to the memory array portion of each of the dynamic RAMs has its absolute value set at or near 2.5 V, thereby to produce the effect that reduction in the power consumption of the memory card can be attained while a withstand voltage characteristic required of memory cells is lowered, in other words, while the memory cells have their size rendered smaller and their integration density rendered higher.

(5) In the above items (1) - (4), an insulator film which corresponds to the information storing node of each memory cell is made of tantalum oxide ($Ta_2O_5$), thereby to produce the effect that the withstand voltage characteristic of the memory cells can be enhanced to promote reducing the size thereof and heightening the integration density thereof.

(6) In the above item (5), the memory cells are fabricated as STC type or crown type ones, thereby to produce the effect that the smaller size and higher integration density of the memory cells can be facilitated more.

(7) In the above items (1) - (6), the memory card is provided with a voltage dropping circuit by which an internal supply voltage corresponding to the memory cells is formed on the basis of a supply voltage externally fed, thereby to produce the effects that supply voltages to be fed to the memory cards can be unified and that the internal supply voltage can be stabilized.

(8) In the above items (1) - (7), the memory card is provided with a secondary battery and is so constructed that the secondary battery can be charged when the memory card is connected to the external equipment such as personal computer, thereby to produce the effect that the number of times of the replacement of the battery can be decreased to serve the convenience of the user.

(9) In the above item (8), the memory card is provided with a solar battery which is connected substantially in a parallel relationship with the secondary battery, thereby to produce the effect that the burden of the secondary battery in the case where the memory card is not connected to the external equipment such as personal computer can be relieved to prolong the service period of the secondary battery.

(10) In the above item (9), the supply voltage to be fed to the memory card or the internal supply voltage of the memory card has its absolute value set to be integral times the unit electromotive force of the secondary battery or the solar battery, thereby to produce the effect that the construction of the power source portion of the memory card can be simplified.

(11) A card holder which is constructed so as to be capable of easily connecting a memory card thereto or detaching the memory card therefrom and which can conserve the stored content of the memory card for long is prepared, thereby to produce the effect that the memory card can be kept in custody reliably and efficiently.

(12) In the above item (11), the card holder is furnished with an auxiliary memory such as magnetic disk unit and is endowed with the function of transferring the stored content of the memory card into the auxiliary memory, thereby to produce the effect that data etc. written on the memory card as the processed result of a personal computer or the like can be held efficiently and for long.

(13) In the above items (11) and (12), the card holder is endowed with the function of copying the system program of an operating system or the like, processed data, etc. stored in the auxiliary memory, onto a plurality of memory cards, thereby to produce the effect that the write operations of the memory cards can be rendered efficient to relieve the user's burden of the operation.

(14) In the above items (11) - (13), the card holder is endowed with the function of charging the secondary battery of the memory card, thereby to produce the effect that while the copy or transfer process of the memory card is being executed, the charging of the secondary battery can be performed in parallel to relieve the user's burden of processing.

(15) In the above items (11) - (14), the card holder is adapted to connect a plurality of memory cards simultaneously, thereby to produce the effect that the transfer or copy process and the charging process can be rendered efficient.

Although, in the above, the invention made by the inventors has been concretely described in conjunction with embodiments, it is needless to say that this invention is not restricted to the foregoing embodiments, but that it can be variously altered within a scope not departing from the purport thereof. By way of example, in Fig. 1, the personal computer may well be capable of connecting a plurality of memory cards or may well conjointly have the functions of a card holder. The system architecture of the personal computer is at will, and how to connect the display unit, keyboard, printer, modem device, etc. is not restricted by the embodiment. The personal computer may well comprise an internal battery corresponding to the supply voltage VCCP, and the polarity and absolute value of the supply voltage are optional. In Fig. 2, the personal computer need not be specified to the note laptop type, and the methods of installing the individual portions and the positions of these portions are optional. In Fig. 3, the dynamic RAMs to be disposed in the memory card may be in any desired number, and the storage capacities of each dynamic RAM and the memory card are not limited. Moreover, the memory card may well include a semiconductor memory, for example, read-only memory together with the dynamic RAMs. In this case, software can be set in the memory card beforehand by, for example, storing a system program in the read-only memory. The refresh control portions RFC as shown in the figure may well be individually disposed in the respective dynamic RAMs. Besides, the secondary battery BAT and solar battery SBAT may well have their output voltages set at the internal supply voltage VCL directly. Regarding the scheme of the signals on the system bus S-BUS and in the memory card, multifarious examples will be thought out. In Fig. 4, the card case CC may well be integrated with the card proper by, for example, molding, and the shape and concrete layout of the card are at will. In Fig. 5, the memory array MARY of the dynamic RAM may well include a plurality of memory mats or sub memory arrays. Moreover, the number of bits of data items which are simultaneously input to or output from the dynamic RAM is as desired, and the number of the addresses of the dynamic RAM is not limited. In Fig. 6, the MOSFETs Q1 and Q2 may well be substituted by other switch means. It is also allowed to interpose buffer means, for example, the charging circuit CHG between the secondary battery BAT and the solar battery SBAT. The absolute value of the internal supply voltage VCL need not always be 2.5 V, but it may well be a value approximate thereto. The practicable arrangement of the memory-card power source portion POWM is not restricted by the embodiment. In Fig. 8 or Fig. 9, the practicable structure of the memory cell is optional, and a memory cell different from the STC type or crown type one may well be adopted. In Figs. 10 and 11, the card holder MCH may well be adapted to connect only one memory card or at least six memory cards, and it may well be endowed with any function not explained before. The auxiliary memory to be disposed in the card holder MCH may well differ from the magnetic disk unit, and it may well employ, for example, a magnetic tape unit conjointly. The practicable internal arrangement of the card holder MCH and the mounting method thereof are not restricted by the embodiment.

In the above, the invention made by the inventors has been chiefly described as to the cases of applications to a personal computer and a memory card and a card holder therefor, which lie in the field of utilization forming the background of the invention. However, this invention is not restricted to the applications, but it is also applicable to various digital processors, for example, a work station and a word processor and to various memory cards and card holders having similar constructions. This invention is extensively applicable to any digital processor having, at least, a storage device, any memory card basically configured of semiconductor memories, and any custody means for the memory cards.

Effects which are achieved by typical aspects of performance of this invention, will be briefly explained below: The main storage and auxiliary storage of a digital processor such as personal computer are constructed of a memory card of large capacity basically configured of semiconductor memories in each of which an internal supply voltage to be fed to the memory array portion thereof has its absolute value set at or near 2.5 V, an insulator film corresponding to the information storing node of each of the memory cells of the memory array portion is formed of tantalum oxide exhibiting a comparatively good withstand voltage property, and a rechargeable secondary battery is disposed in the memory card. In addition, a card holder is prepared which has the function of refreshing the stored content of the memory card or transferring it into a built-in auxiliary memory so as to conserve it for long, the function of copying the system program of an operating system or the like from the auxiliary memory onto the memory card, and the function of charging the secondary battery of the memory card. Thus, the storage system of the personal computer or the like is unified and is dedicated to exclusive use every user or every processing content, whereby the user's burden of processing can be relieved, and the throughput of the personal computer or the like can be enhanced. Moreover, reduction in the power consumption of the personal computer or the like can be promoted in conformity with the heightened integration density and enlarged capacity of the memory card, and the stored content of the memory card can be conserved efficiently and for long.

## Claims

1. A digital processor comprising a central processing unit (CPU), and a storage device which includes semiconductor memories and which functions as a main storage and an auxiliary storage, said main storage and said auxiliary storage having a non-hierarchic storing architecture.

2. A digital processor as defined in Claim 1, wherein said storage device is in a shape in which it is detachably connected to said digital processor.

3. A digital processor as defined in Claim 2, wherein said storage device is in the shape of a card.

4. A digital processor as defined in Claim 3, wherein said storage device is exclusively used in correspondence with a processing content of said digital processor and is selectively connected to said digital processor for the processing content.

5. A digital processor as defined in Claim 4, wherein said each semiconductor memory is constructed of a dynamic RAM, a memory array portion of which is fed with an internal supply voltage having an absolute value substantially equal to 2.5 volts.

6. A digital processor as defined in Claim 4, wherein said digital processor is in a portable shape.

7. A memory card as defined in Claim 5, wherein an insulator film which corresponds to an information storing node of each of memory cells constituting said memory array portion is made of tantalum oxide ($Ta_2O_5$).

8. A memory card as defined in Claim 7, wherein said each memory cell is a member selected from the group consisting of a stacked capacitor type memory cell and a crown type memory cell.

9. A memory card as defined in Claim 8, comprising a voltage dropping circuit which forms said internal supply voltage on the basis of a predetermined external supply voltage.

10. A memory card as defined in Claim 9, comprising a secondary battery which feeds either of said external supply voltage and said internal supply voltage when said memory card is not connected to said digital processor.

11. A memory card as defined in Claim 10, comprising a solar battery which is connected substantially in parallel with said secondary battery.

12. A memory card as defined in Claim 11, wherein an absolute value of either of said external supply voltage and said internal supply voltage is set integral times as large as unit electromotive force of said secondary battery.

# FIG. 1

# FIG. 2

## FIG. 3

# FIG. 4

BATTERY WINDOW FOR LIGHTING
BW

CARD CASE
CC

LSI17(IFC,RFC)

LSI18(POWM)

CON1(P)

BAT

LSI13~LSI16(RAM30~RAM33)
LSI9~LSI12(RAM20~RAM23)
LSI5~LSI 8(RAM10~RAM13)
LSI1~LSI 4(RAM00~RAM03)

CB
CARD BASE PLATE

SBAT
SOLAR BATTERY

EP 0 447 057 A2

FIG. 5

## FIG. 6

## FIG. 7

## FIG. 8

STC

CI(Ta₂O₅)

PL(VCP)

Bj

CI(Ta₂O₅)

PL(VCP)

CN

Wi-1

Wi
(G1)

La(S1)

(D1)

Lb

(D2)

Lc(S2)

Wi+1
(G2)

CN

Wi+2

SUB(P)

## FIG. 9

CROWN

PL(VCP)

Bj

CI(Ta₂O₅)

CN

Wi-1

La(S1)

Wi
(G1)

(D1)

Lb

(D2)

Lc(S2)

Wi+1
(G2)

Wi+2

SUB(P)

FIG. 10

# FIG. 11